# EUROPEAN PATENT APPLICATION

(11) **EP 2 584 555 A1**
(43) Date of publication of application: **24.04.2013**
(21) Application number: 12770409.6
(22) Date of filing: 11.07.2012
(51) Int. Cl.: G09G 3/36, G02F 1/13, G02B 27/26

(54) **DISPLAY PANEL AND DISPLAY DEVICE**

(30) Priority: 13.07.2011 CN 201120246011 U
(71) Applicant: Boe Technology Group Co. Ltd., Beijing 100015 (CN)
(72) Inventor: PENG, Kuanjun, Beijing 100176 (CN); NAGAYAMA, Kazuyoshi, Beijing 100176 (CN); LV, Jing, Beijing 100176 (CN)
(74) Representative: Klunker . Schmitt-Nilson . Hirsch
(86) International application number: PCT/CN2012/078483
(87) International publication number: WO 2013/007196

(57) **Abstract**

Embodiments of the disclosed technology provide a display panel and a display device. The display panel comprises a plurality of pixels arranged in a matrix, wherein each of the pixels comprises a first sub-pixel region and a second sub-pixel region, the first sub-pixel region comprises one or more color sub-pixels, and the second sub-pixel region comprises one or more white sub-pixels. The display device according to the disclosed technology comprises the above display panel.

## Description

### FIELD OF THE INVENTION

Embodiments of the disclosed technology relates to a display panel and a display device.

### BACKGROUND

In these years, three-dimensional (3D) stereoscopic display is paid more and more attentions. Among various 3D stereoscopic displaying technologies, a polarization type 3D displaying technology is an important development direction due to its advantages such as low cost and being free of flicker.

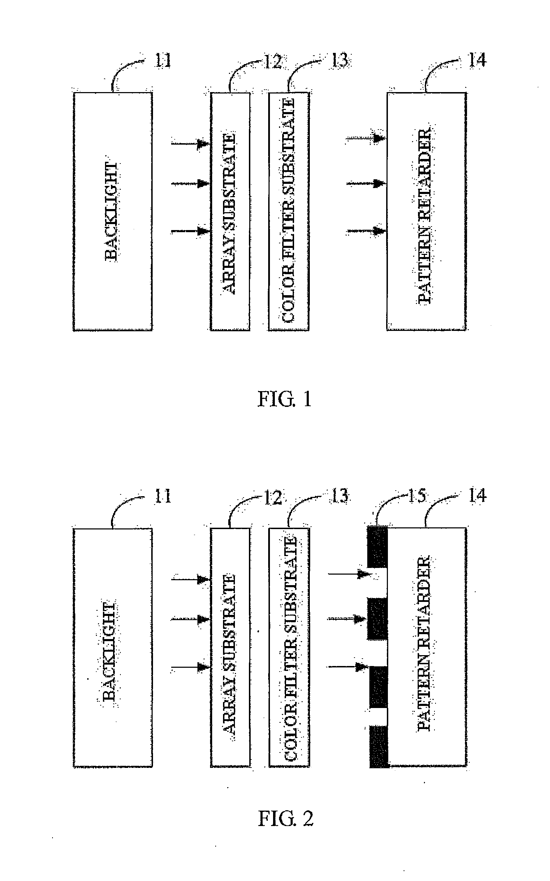

The polarization type 3D displaying has a basic principle as follows. As shown in Fig. 1, light emitted from a backlight unit 11 (indicated by arrows) is transmitted by a liquid display unit composed of an array substrate 12 and a color filter substrate 13, then the polarization state of the emitted light from odd row pixels and even row pixels of the display panel is changed by a pattern retarder 14, therefore, a left-eye image and a right-eye image can be distinguished from each other by using a set of polarization glasses so that the left-eye image enters into the left eye and the right-eye image enters into the right eye, thus a 3D effect is formed. However, in such a manner, it is easy for the left-eye image to enter into the right eye through the pattern retarder corresponding to the right eye and for the right-eye image to enter into the left-eye through the pattern retarder corresponding to the left eye so as to form a crosstalk, which leads to a very small viewing angle in the vertical direction of the 3D display.

As shown in Fig. 2, in order to overcome the above drawback, black strips 15 are disposed on the pattern retarder 14 to block the crosstalk between the left-eye image and the right-eye image, so as to obtain a larger viewing angle in the vertical direction. However, this solution creates another problem: due to the presence of the black strips, a transmittance of the display panel will be reduced when it is operated in the 2D mode, which leads to a reduced brightness in the 2D mode.

### SUMMARY

An embodiment of the disclosed technology provides a display panel, comprising a plurality of pixels arranged in a matrix, wherein each of the pixels comprises a first sub-pixel region and a second sub-pixel region, the first sub-pixel region comprises one or more color sub-pixels, and the second sub-pixel region comprises one or more white sub-pixels.

Another embodiment of the disclosed technology provides a display device, comprising: a display panel according to the above embodiment; a sequence circuit, transmitting displaying signals to the display panel in a 2D mode or a 3D mode; a controller, controlling the sequence circuit to transmit the displaying signals according to the 2D mode or the 3D mode; and a pattern retarder, disposed in front of the display panel, and converting light emitted from the display panel into fist polarized light and second polarized light with different polarization states.

### BRIEF DESCRIPTION OF THE DRAWINGS

Fig. 1 is a diagram showing a principle of a polarization type 3D displaying in the prior art;

Fig. 2 is a diagram showing a principle of a polarization type 3D displaying with black strips in the prior art;

Fig. 3 is a structural schematic view showing a pixel of a display panel according to an embodiment of the disclosed technology;

Fig. 4 is a structural schematic view showing a pixel of a display panel according to another embodiment of the disclosed technology;

Fig. 5 is a schematic view showing a displaying effect of a pixel in a 2D displaying mode;

Fig. 6 is a schematic view showing a displaying effect of a pixel in a 3D displaying mode;

Fig. 7 is a structural schematic view showing a pixel of a display panel according to another embodiment of the disclosed technology; and

Fig. 8 is a structural schematic view showing a display device according to an embodiment of the disclosed technology.

### DETAILED DESCRIPTION

Embodiments of the disclosed technology now will be described more clearly and fully hereinafter with reference to the accompanying drawings.

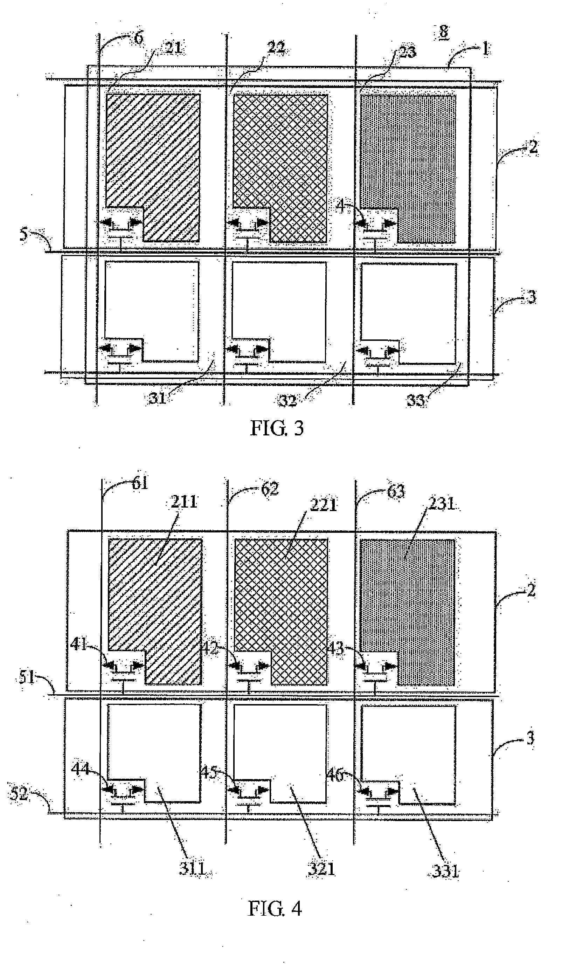

An embodiment of the disclosed technology provides a display panel comprising a plurality of pixels 1 arranged in a matrix, wherein each of the pixels 1 comprises a first sub-pixel region 2 and a second sub-pixel region 3, the first sub-pixel region 2 comprises one or more color sub-pixels, and the second sub-pixel region 3 comprises one or more white sub-pixels. Fig. 3 is a structural schematic view showing a pixel of a display panel according to an embodiment of the disclosed technology, wherein one pixel is shown. As shown in Fig. 3, the first sub-pixel region 2 and the second sub-pixel region 3 are arranged in a vertical direction, and the first sub-pixel region 2 is located above the second sub-pixel region 3. The first sub-pixel regions 2 and the second sub-pixel regions 3 in each row of pixels constitute a color sub-pixel row and a white sub-pixel row, and the color sub-pixel rows and the white sub-pixel rows on the display panel are alternatively disposed in the vertical direction. The first sub-pixel region 2 comprises three sub-pixels of red sub-pixel 21, green sub-pixel 22 and blue sub-pixel 23 arranged sequentially in a horizontal direction, and the second sub-pixel region 3 comprises three white sub-pixels 31, 32 and 33 arranged sequentially in the horizontal direction. In the present specification, unless where otherwise stated, the "horizontal direction" refers to a direction parallel to a connection line between two eyes of a viewer within a plane of the display panel, and the "vertical direction" refers to a direction perpendicular to the horizontal direction within the plane of the display panel. The structure as shown in Fig. 3 is only an example. For example, the number of the sub-pixels in each of the first and second sub-pixel regions 2 and 3 is not limited to three, but may be any number of one or more. The colors of the above color sub-pixels are not limited to the three colors of red, green and blue, but may be cyan, magenta, yellow, and etc.

The embodiment as shown in Fig. 3 is a liquid crystal panel, for example, comprising a color filter substrate (not shown) and an array substrate 8. For example, the color filter substrate comprises color filters corresponding to each of the color sub-pixels and transparent layers corresponding to each of the white sub-pixels. The array substrate 8 comprises pixel electrodes and thin film transistors 4 corresponding to each of the sub-pixels, and gate lines 5 and data lines 6 perpendicular to each other. However, the display panel according to the disclosed technology is not limited to the liquid crystal panel, and may be an organic light emitting diode (OLED) display and etc.

Each of the white sub-pixels may have a quadrangle shape, or may have other regular or irregular shapes. Any two of the white sub-pixels may have the same length and the same width; alternatively, all of the three white sub-pixels have the same length but different widths; alternatively, the three white sub-pixels have different lengths and different width; alternatively, two of the white sub-pixels have the same size. Also, the above color sub-pixels may be designed with any arbitrary shape and size.

According to the embodiment of the disclosed technology, one pixel is divided into six sub-pixels including three color sub-pixels and three white sub-pixels. In a 2D mode, the conventional RGB signals are converted into RGBWWW signals so that the white sub-pixels can emit light with suitable brightness, which avoids the problems of low brightness in the 2D mode in the prior art; in a 3D mode, the white sub-pixels are controlled to display in black according to black/grey signals, which can decrease image crosstalk and enhance the viewing angle in the vertical direction.

Hereinafter, the display panel according to the disclosed technology will be described in further detail by referring to an embodiment. Each pixel 1 in the display panel is divided into two sub-pixel regions, i.e., the first sub-pixel region 2 located at a first row and the second sub-pixel region 3 located at a second row. Each pixel 1 corresponds to two gate lines 5 and three data lines 6. As shown in Fig. 4, for example, a pixel electrode 211 on the array substrate corresponding to the first color sub-pixel 21 of the first sub-pixel region 2 is connected with a first gate line 51 and a first data line 61 through a first thin film transistor 41, a pixel electrode 221 on the array substrate corresponding to the second color sub-pixel 22 of the first sub-pixel region 2 is connected with the first gate line 51 and a second data line 62 through a second thin film transistor 42, a pixel electrode 231 on the array substrate corresponding to the third color sub-pixel 23 of the first sub-pixel region 2 is connected with the first gate line 51 and a third data line 63 through a third thin film transistor 43. After the gate line is turned on, the RGB signals are transmitted to the first sub-pixel region 2 through the data lines so that each of the color sub-pixels can perform color display with certain brightness. In addition, a pixel electrode 311 on the array substrate corresponding to the first white sub-pixel 31 of the second sub-pixel region 3 is connected with a second gate line 52 and the first data line 61 through a fourth thin film transistor 44, a pixel electrode 321 on the array substrate corresponding to the second white sub-pixel 32 of the second sub-pixel region 3 is connected with the second gate line 52 and the second data line 62 through a fifth thin film transistor 45, and a pixel electrode 331 on the array substrate corresponding to the third white sub-pixel 33 of the second sub-pixel region 3 is connected with the second gate line 52 and the third data line 63 through a sixth thin film transistor 46. The white sub-pixels are turned on or off according to signals provided by the gate line 52.

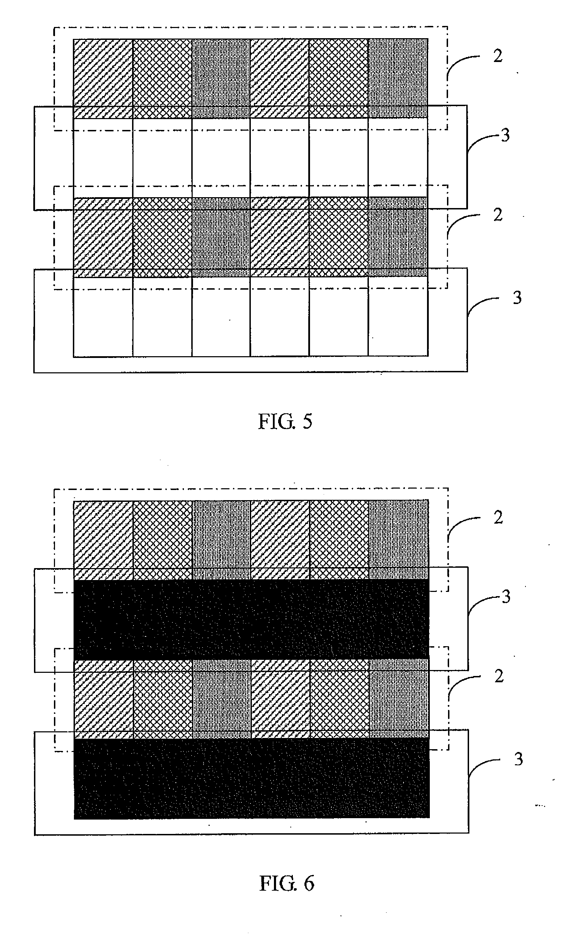

When a viewer chooses a 2D mode to display images, the second sub-pixels region 3 in the display panel can emit light with suitable brightness according to the RGBWWW signals. Since the light transmittance in the RGBWWW displaying manner is higher than that in the RGB displaying manner, the brightness of the whole display panel can be enhanced. Specifically, in the 2D mode, when the first gate line 51 is turned on, the first data line 61 transmits a red (R) displaying signal to the first color sub-pixel 21, the second data line 62 transmits a green (G) displaying signal to the second color sub-pixel 22, and the third data line 63 transmits a blue (B) displaying signal to the third color sub-pixel 23; when the second gate line 52 is turned on, the first data line 61 transmits a white (W) displaying signal to the first white sub-pixel 31, the second data line 62 transmits a white (W) displaying signal to the second white sub-pixel 32, and the third data line 63 transmits a white (W) displaying signal to the third white sub-pixel 33. The brightness corresponding to the white displaying signals is an average value of brightness corresponding to the R displaying signal, the G displaying signal and the B displaying signal; alternatively, it may be a determined value. Fig. 5 is a schematic view showing the displaying effect of the pixel in the 2D mode, wherein the first sub-pixel region 2 is in normal displaying, and the second sub-pixel region 3 displays with suitable brightness.

When a viewer chooses a 3D mode to display images, the second sub-pixel region 3 in the display panel displays in black so as to decrease the image crosstalk and enhance the viewing angle in the vertical direction. Specifically, in the 3D mode, when the first gate line 51 is turned on, the first data line 61 transmits a red (R) displaying signal to the first color sub-pixel 21, the second data line 62 transmits a green (G) displaying signal to the second color sub-pixel 22, and the third data line 63 transmits a blue (B) displaying signal to the third color sub-pixel 23; when the second gate line 52 is turned on, the first data line 61 transmits a black/grey displaying signal to the first white sub-pixel 31, the second data line 62 transmits a black/grey displaying signal to the second white sub-pixel 32, and the third data line 63 transmits a black/grey displaying signal to the third white sub-pixel 33. Fig. 6 is a schematic view showing the displaying effect of the pixel in the 3D mode, wherein the first sub-pixel region 2 is in normal displaying, and the second sub-pixel region 3 displays in black so as to function as a black matrix, thereby the viewing angle in the vertical direction in the 3D mode is enhanced.

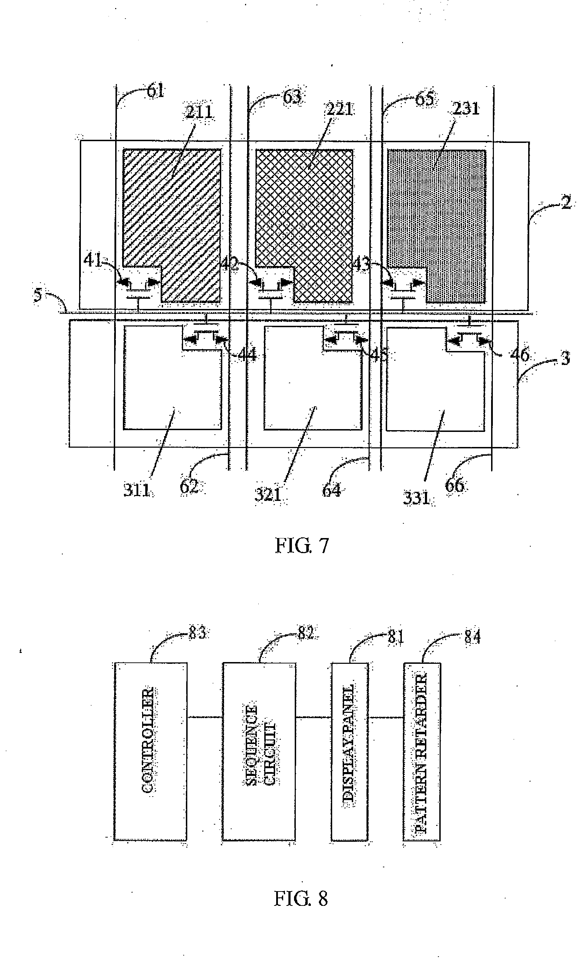

As shown in Fig. 7, in another embodiment of the disclosed technology, each pixel 1 corresponds to one gate line 5 and six data lines 6. Specifically, a pixel electrode 211 on the array substrate corresponding to the first color sub-pixel 21 of the first sub-pixel region 2 is connected with the gate line 5 and a first data line 61 through a first thin film transistor 41, a pixel electrode 221 on the array substrate corresponding to the second color sub-pixel 22 of the first sub-pixel region 2 is connected with the gate line 5 and a third data line 63 through a second thin film transistor 42, a pixel electrode 231 on the array substrate corresponding to the third color sub-pixel 23 of the first sub-pixel region 2 is connected with the gate line 5 and a fifth data line 65 through a third thin film transistor 43. After the gate line is turned on, the RGB signals are transmitted to the first sub-pixel region 2 through the data lines so that each of the color sub-pixels can perform color display with certain brightness. In addition, a pixel electrode 311 on the array substrate corresponding to the first white sub-pixel 31 of the second sub-pixel region 3 is connected with the gate line 5 and a second data line 62 through a fourth thin film transistor 44, a pixel electrode 321 on the array substrate corresponding to the second white sub-pixel 32 of the second sub-pixel region 3 is connected with the gate line 5 and a fourth data line 64 through a fifth thin film transistor 45, and a pixel electrode 331 on the array substrate corresponding to the third white sub-pixel 33 of the second sub-pixel region 3 is connected with the gate line 5 and the sixth data line 66 through a sixth thin film transistor 46. The white sub-pixels are turned on or off according to signals provided by the gate line 5.

When a viewer chooses a 2D mode to display images, the second sub-pixels region 3 in the display panel can emit light with suitable brightness according to the RGBWWW signals. Since the light transmittance in the RGBWWW displaying manner is higher than that in the RGB displaying manner, the brightness of the whole display panel can be enhanced. Specifically, in the 2D mode, when the gate line 5 is turned on, the first data line 61 transmits a red (R) displaying signal to the first color sub-pixel 21, the third data line 63 transmits a green (G) displaying signal to the second color sub-pixel 22, and the fifth data line 65 transmits a blue (B) displaying signal to the third color sub-pixel 23, the second data line 62 transmits a white (W) displaying signal to the first white sub-pixel 31, the fourth data line 64 transmits a white (W) displaying signal to the second white sub-pixel 32, and the sixth data line 66 transmits a white (W) displaying signal to the third white sub-pixel 33. For example, the brightness corresponding to the white displaying signals is an average value of brightness corresponding to the R displaying signal, the G displaying signal and the B displaying signal. The displaying effect of the pixel in the 2D mode is shown in Fig. 5.

When a viewer choose a 3D mode to display images, the second sub-pixel region 3 in the display panel displays in black so as to function as a black matrix to block light and enhance the 3D effect. Specifically, in the 3D mode, when the gate line 5 is turned on, the first data line 61 transmits a red (R) displaying signal to the first color sub-pixel 21, the third data line 63 transmits a green (G) displaying signal to the second color sub-pixel 22, and the fifth data line 65 transmits a blue (B) displaying signal to the third color sub-pixel 23, the second data line 62 transmits a black/grey displaying signal to the first white sub-pixel 31, the fourth data line 64 transmits a black/grey displaying signal to the second white sub-pixel 32, and the sixth data line 66 transmits a black/grey displaying signal to the third white sub-pixel 33. The displaying effect of the pixel in the 3D mode is shown in Fig. 6.

The disclosed technology also provides a display device. As shown in Fig. 8, the display device comprises a display panel 81, the display 81 being any one of the displaying panels according to the embodiments of the disclosed technology; a sequence circuit 82, transmitting displaying signals to the display panel in a 2D mode or a 3D mode; a controller 83, controlling the sequence circuit 82 to transmit the displaying signals according to the 2D mode or the 3D mode; and a pattern retarder 84, disposed in front of the display panel 81, and converting light emitted from the display panel 81 into fist polarized light and second polarized light.

In the 2D mode, the controller 83 converts RGB signals into RGBWWW signals, and transmits them to the display panel 81 via the sequence circuit 82.

In the 3D mode, the controller 83 transmits black/grey signals to the display panel via the sequence circuit 82, so that the white sub-pixels in the second sub-pixel region for each pixel are controlled to display in black.

It can be known from the above that, in the display device according to the embodiment of the disclosed technology, one pixel is divided into six sub-pixels including three color sub-pixels and three white sub-pixels. In a 2D mode, the conventional RGB signals are converted into RGBWWW signals so that the white sub-pixels can emit light with suitable brightness, which avoids the problems of low brightness in the 2D mode in the prior art; in a 3D mode, the white sub-pixels are controlled to display in black according to black/grey signals, which can decrease image crosstalk and enhance the viewing angle in the vertical direction.

It is obvious that various modifications and alternations can be made on the embodiment of the disclosed technology by those skilled in the art without departing from the spirit and scope of the disclosed technology. Thus, if such modifications and alternations of the disclosed technology are included in the scope as defined in the appended claims or the equivalents thereof, then the disclosed technology intends to include such modifications and alternations.

## Claims

1. A display panel, comprising a plurality of pixels arranged in a matrix,
wherein each of the pixels comprises a first sub-pixel region and a second sub-pixel region, the first sub-pixel region comprises one or more color sub-pixels, and the second sub-pixel region comprises one or more white sub-pixels.

2. The display panel of Claim 1, wherein the first sub-pixel region and the second sub-pixel region are arranged in a vertical direction in a plane of the display panel, and the first sub-pixel regions and the second sub-pixel regions in each row of pixels constitute a color sub-pixel row and a white sub-pixel row, and the color sub-pixel rows and the white sub-pixel rows on the display panel are alternatively disposed in the vertical direction.

3. The display panel of Claim 1 or 2, wherein the first sub-pixel region comprises a first color sub-pixel, a second color sub-pixel and a third color sub-pixel; and the second sub-pixel region comprises a first white sub-pixel, a second white sub-pixel, and a third white sub-pixel.

4. The display panel of Claim 3, wherein the first, second and third color sub-pixels are arranged in a horizontal direction in the plane of the display panel; and the first, second and third white sub-pixels are also arranged in the horizontal direction.

5. The display panel of Claim 3 or 4, wherein the first color sub-pixel is a red sub-pixel, the second color sub-pixel is a green sub-pixel, and the third color sub-pixel is a blue sub-pixel.

6. The display panel of any of Claims 3-5, wherein the display panel comprises a color filter substrate and an array substrate, and
wherein the color filter substrates comprises color filters corresponding to the first, second and third color sub-pixels and transparent layers corresponding to the white sub-pixels, and the array substrate comprises pixel electrodes and thin film transistors corresponding to each of the sub-pixels, and gate lines and data lines perpendicular to each other.

7. The display panel of any of Claims 3-6, wherein each pixel corresponds to two gate lines and three data lines.

8. The display panel of Claim 7, wherein a pixel electrode corresponding to the first color sub-pixel of the first sub-pixel region is connected with a first gate line and a first data line through a first thin film transistor, a pixel electrode corresponding to the second color sub-pixel of the first sub-pixel region is connected with the first gate line and a second data line through a second thin film transistor, a pixel electrode corresponding to the third color sub-pixel of the first sub-pixel region is connected with the first gate line and a third data line through a third thin film transistor, a pixel electrode corresponding to the first white sub-pixel of the second sub-pixel region is connected with a second gate line and the first data line through a fourth thin film transistor, a pixel electrode corresponding to the second white sub-pixel of the second sub-pixel region is connected with the second gate line and the second data line through a fifth thin film transistor, and a pixel electrode corresponding to the third white sub-pixel of the second sub-pixel region is connected with the second gate line and the third data line through a sixth thin film transistor.

9. The display panel of any of Claims 3-6, wherein each pixel corresponds to one gate line and six data lines.

10. The display panel of Claim 9, wherein a pixel electrode corresponding to the first color sub-pixel of the first sub-pixel region is connected with the gate line and a first data line through a first thin film transistor, a pixel electrode corresponding to the second color sub-pixel of the first sub-pixel region is connected with the gate line and a third data line through a second thin film transistor, a pixel electrode corresponding to the third color sub-pixel of the first sub-pixel region is connected with the gate line and a fifth data line through a third thin film transistor, a pixel electrode corresponding to the first white sub-pixel
of the second sub-pixel region is connected with the gate line and a second data line through a fourth thin film transistor, a pixel electrode corresponding to the second white sub-pixel of the second sub-pixel region is connected with the gate line and a fourth data line through a fifth thin film transistor, and a pixel electrode corresponding to the third white sub-pixel of the second sub-pixel region is connected with the gate line and a sixth data line through a sixth thin film transistor.

11. A display device, comprising:
a display panel according to any of Claims 1-10;
a sequence circuit, transmitting displaying signals to the display panel in a 2D mode or a 3D mode;
a controller, controlling the sequence circuit to transmit the displaying signals according to the 2D mode or the 3D mode; and
a pattern retarder, disposed in front of the display panel, and converting light emitted from the display panel into fist polarized light and second polarized light with different polarization states.

12. The display device of Claim 11, wherein the first sub-pixel region comprises a first color sub-pixel, a second color sub-pixel and a third color sub-pixel; and the second sub-pixel region comprises a first white sub-pixel, a second white sub-pixel, and a third white sub-pixel.

13. The display device of Claim 12, wherein the first color sub-pixel is a red sub-pixel, the second color sub-pixel is a green sub-pixel, and the third color sub-pixel is a blue sub-pixel.

14. The display device of any of Claims 11-13, wherein, in the 2D mode, the controller converts RGB signals into RGBWWW signals, and the RGBWWW signals are transmitted to the display panel via the sequence circuit.

15. The display device of any of Claims 11-13, wherein, in the 3D mode, the controller transmits black/grey singles to the display panel via the sequence circuit so as to control the white sub-pixels in the second sub-pixel region of each pixel to display in black.
